# EUROPEAN PATENT SPECIFICATION

(11) **EP 4 550 381 B1**
(45) Date of publication and mention of the grant of the patent: **22.10.2025**
(21) Application number: 24209966.1
(22) Date of filing: 30.10.2024
(51) Int. Cl.: H01H 83/04, H01H 71/12

(54) **DOUBLE-BREAKPOINT TEST MECHANISM APPLIED TO CIRCUIT BREAKER AND CIRCUIT BREAKER**
TESTMECHANISMUS MIT DOPPELTEM BRUCHPUNKT FÜR SCHUTZSCHALTER UND SCHUTZSCHALTER
MÉCANISME DE TEST À DOUBLE POINT DE RUPTURE APPLIQUÉ À UN DISJONCTEUR ET DISJONCTEUR

(30) Priority: 31.10.2023 CN 202311427728
(43) Date of publication of application: 07.05.2025
(73) Proprietor: Xiamen Hongfa Automotive Electronics Co., Ltd., Xiamen, Fujian 361021 (CN)
(72) Inventor: JIA, Yongshuai, Xiamen, 361021 (CN); CHEN, Min, Xiamen, 361021 (CN); ZHOU, Yanhai, Xiamen, 361021 (CN); LAI, Senlin, Xiamen, 361021 (CN); WENG, Zhizhen, Xiamen, 361021 (CN); LIN, Cong, Xiamen, 361021 (CN)
(74) Representative: Hunter, Christopher Jack Owen

(56) References cited:
- EP-A2- 0 320 929
- EP-B1- 0 231 732
- EP-B1- 0 914 666
- CN-A- 110 739 194
- CN-U- 209 981 152

## Description

### TECHNICAL FIELD

The present disclosure relates to a field of switching appliances, in particular to a test mechanism for a circuit breaker.

### BACKGROUND

The relevant test mechanisms for circuit breakers are generally divided into two types: single-breakpoint test mechanisms and double-breakpoint test mechanisms. The single-breakpoint test mechanism can achieve conduction of a test circuit when a test button is pressed, and has a relatively simple structure. However, the disadvantage of the single-breakpoint test mechanism lies in that when the circuit breaker is opened, an output terminal of the circuit breaker will have a voltage to ground due to the conduction of the test circuit if the test button is pressed, which may result in a risk of electric shock during use. To avoid this risk, some test mechanisms include one additional breakpoint that only closes and turns on when the circuit breaker is closed, forming a double-breakpoint test mechanism to improve safety performance, like in European Patent EP 0 914 666 B1. Nevertheless, currently relevant double-breakpoint test mechanisms include the additional breakpoint by adding an extra conductive component, which increases costs and product assembling steps and does not facilitate structural upgrading of the relevant single-breakpoint test mechanisms.

### SUMMARY

Accordingly, directed at the above problems, the present disclosure provides a double-breakpoint test mechanism that is structurally optimized and applied to a circuit breaker, and also provides a circuit breaker having the double-breakpoint test mechanism.

The present disclosure is implemented by the following technical solutions.

According the present disclosure, a double-breakpoint test mechanism applied to a circuit breaker is provided. The double-breakpoint test mechanism includes: a test button; a test torsion spring; and a first elastic member and a second elastic member, which are configured to provide a reset force and perform contact conduction. The first elastic member and the second elastic member are assembled in a first assembly site and a second assembly site respectively to provide a first reset force and a second reset force for a tripping mechanism of the circuit breaker. When the first elastic member and the second elastic member are in the first assembly site and the second assembly site respectively, a first breakpoint is formed between the test torsion spring and the first elastic member, and a second breakpoint is formed between the first elastic member and the second elastic member. The first elastic member includes a first end close to the test torsion spring and a second end close to the second elastic member. The test torsion spring is pushed by the test button to have a first motion stroke, and the first end of the first elastic member is arranged within a stroke range of the first motion stroke, allowing the test button to push the test torsion spring into contact conduction with the first end of the first elastic member. When the circuit breaker is closed, the second end of the first elastic member is pushed by the tripping mechanism to have a second motion stroke, and the second elastic member is arranged within a stroke range of the second motion stroke, allowing the tripping member to push the second end of the first elastic member into contact conduction with the second elastic member when the circuit breaker is closed.

In an embodiment, preferably, both the first elastic member and the second elastic member are torsion springs; two torsion arms of the first elastic member serve as the first end and the second end; one torsion arm of the second elastic member is arranged within the stroke range of the second motion stroke.

In an embodiment, preferably, the double-breakpoint test mechanism further includes a third elastic member and a test resistor. One end of the third elastic member keeps contact conduction with the second elastic member through elastic force, and another end of the third elastic member keeps contact conduction with the test resistor through elastic force.

In an embodiment, preferably, the test button and the test resistor are spaced apart, and the first elastic member, the second elastic member and the third elastic member are sequentially arranged between the test button and the test resistor.

In an embodiment, preferably, the second elastic member is a double-torsion spring and includes a first helical portion and a second helical portion, the first helical portion being closer to the test button than the second helical portion.

In an embodiment, preferably, the test torsion spring includes a first contact portion configured to contact the first elastic member, and the first elastic member includes a second contact portion corresponding to the first contact portion, the first contact portion and the second contact portion being staggered opposite to each other; and/or the first elastic member includes a third contact portion configured to contact the second elastic member, and the second elastic member includes a fourth contact portion corresponding to the third contact portion, the third contact portion and the fourth contact portion being staggered opposite to each other.

Based on the above double-breakpoint test mechanism, the present disclosure further provides a circuit breaker, including a circuit breaker unit and a leakage protection unit. The leakage protection unit includes: a tripping mechanism; and a test mechanism that is the above double-breakpoint test mechanism. The leakage protection unit further includes: a first assembly site and a second assembly site, the first elastic member and the second elastic member being assembled in the first assembly site and the second assembly site respectively to provide a first reset force and a second reset force for the tripping mechanism.

In an embodiment, preferably, the circuit breaker further includes a base. The tripping mechanism includes a tripping member, a tripping latch, a lock latch, and a reset member; the tripping member, the lock latch, and the reset member are pivotally connected to the base; the tripping latch is pivotally connected to the tripping member; and the first elastic member and the second elastic member are rotating reset members for the tripping member and the lock latch respectively.

In an embodiment, preferably, the test button is at a left side of the test resistor, and the test resistor is at a right side of the test button; the test button is close to a left end housing of the base, and the test resistor is close to a right end housing of the base; and the first elastic member and the second elastic member are arranged in sequence from left to right between the test button and the test resistor.

The present disclosure has the following advantages or beneficial effects. In the present disclosure, the test circuit is formed by utilizing the first elastic member and the second elastic member already relevant in the original tripping mechanism, so that the components are highly integrated without need for additional conductive components, the structure is simple, and the cost is low.

### BRIEF DESCRIPTION OF THE DRAWINGS

FIG. 1 is a perspective schematic view of a circuit breaker in an open state according to embodiments (part of a base being omitted to show an internal structure of a leakage protection unit);
FIG. 2 is a schematic view of the leakage protection unit according to embodiments;

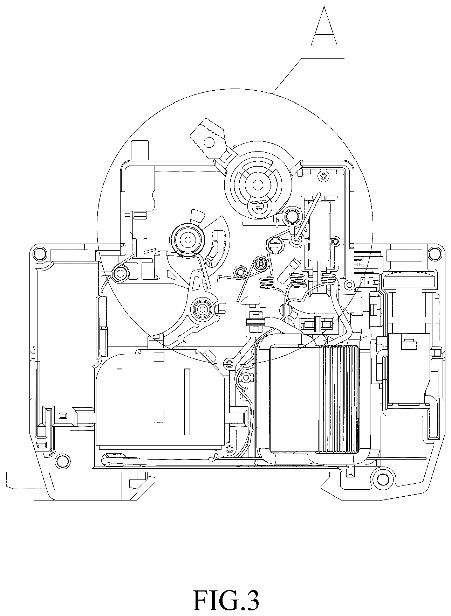

FIG. 3 is a schematic view of a double-breakpoint test mechanism in the open state of the circuit breaker according to embodiments;
FIG. 4 is a partially enlarged view at part A in FIG. 3;

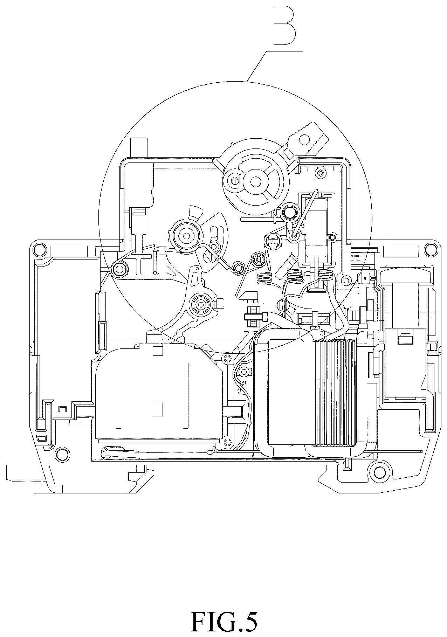

FIG. 5 is a schematic view of the double-breakpoint test mechanism in a closed state of the circuit breaker according to embodiments;
FIG. 6 is a partially enlarged view at part B in FIG. 5;
FIG. 7 is a perspective schematic view of the circuit breaker in the closed state according to embodiments (part of the base being omitted to show an internal structure of the leakage protection unit);
FIG. 8 is a schematic view of a second elastic member according to embodiments.

### DETAILED DESCRIPTION

To further elaborate various embodiments, the present disclosure provides accompanying drawings. These accompanying drawings are part of the present disclosure and are mainly used to illustrate the embodiments, and may be combined with relevant descriptions in the specification to explain operation principles of the embodiments. With reference to these contents, a person skilled in the art should understand other possible embodiments and advantages of the present disclosure. Components in the drawings are not drawn to scale, and similar component symbols are generally used to denote similar components.

The present disclosure will be further described in connection with the accompanying drawings and specific embodiments.

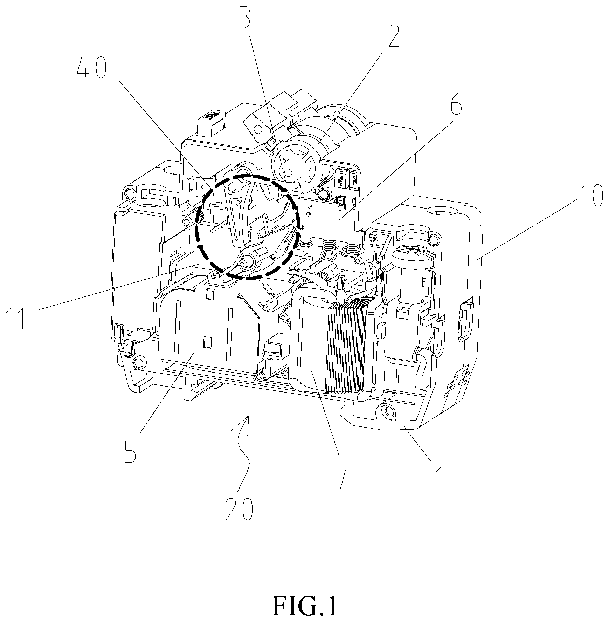

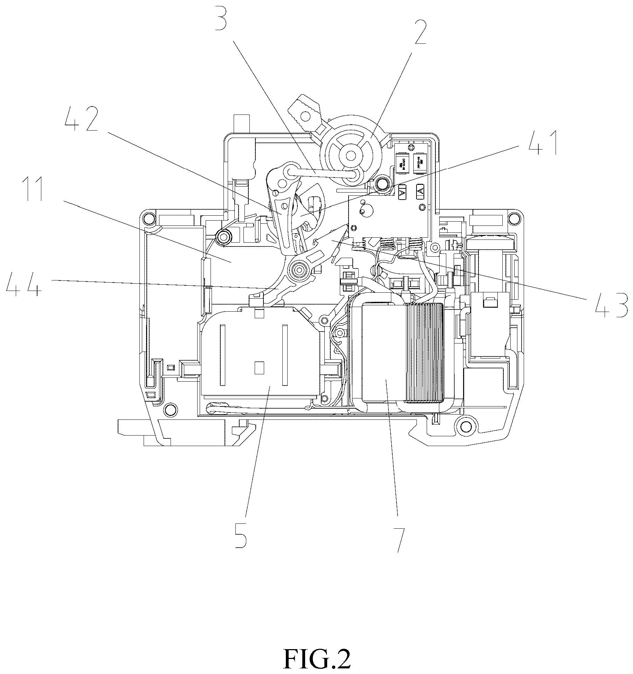

As shown in FIGS. 1-2, as a preferred embodiment of the present disclosure, a circuit breaker, more specifically a residual current protection circuit breaker, is provided, including a circuit breaker unit 10 and a leakage protection unit 20 that are connected in parallel with their poles. The circuit breaker unit 10 is used to achieve functions such as circuit turn-on and turn-off, overload protection, and short-circuit protection. The leakage protection unit 20 is used to detect a leakage current in a circuit and push the circuit breaker unit 10 to open under an action of a tripping mechanism (releasing mechanism) 40, thereby protecting personal safety. The leakage protection unit 20 specifically includes a base 1, a handle 2, a connection rod 3, the tripping mechanism 40, an electromagnetic release 5, a control circuit board 6, and a zero-sequence current transformer 7. The base 1 includes a partition plate 30 configured to separate a L-pole circuit from a N-pole circuit in the circuit breaker unit 10. The tripping mechanism 40 includes a tripping member (releasing member) 41, a tripping latch (releasing latch) 42, a lock latch 43, and a reset member 44. The handle 2, the tripping member 41, the lock latch 43, and the reset member 44 are all rotatably and pivotally connected to the base 1, and the tripping latch 42 is pivotally connected to the tripping member 41. The handle 2 is linked and connected with the tripping latch 42 through the connection rod 3. The lock latch 43 is provided with a curved-hook-shaped locking portion (not labeled in the figures). The tripping latch 42 is provided with a curved-hook-shaped locked portion (not labeled in the figures) that can be buckled with the locking portion.

In an open state of the circuit breaker, the handle 2 is toggled and drives the tripping latch 42 rotate through linkage of the connection rod 3, until the locked portion and the locking portion are buckled due to rotation of the tripping latch. At this time, the lock latch forms a limit on the tripping latch, and the locking portion provides a fulcrum for the tripping latch 42. Under a continuous force of the handle 2, the tripping latch 42 rotates together with the tripping member 41. The tripping member 41 includes a linkage connection portion that extends into the circuit breaker unit 10. The linkage connection portion 41 cooperates with an operating mechanism of the circuit breaker unit 10 to toggle the circuit breaker unit 10 to open when the leakage protection unit 20 is opened.

A main circuit of the circuit breaker unit 10 passes through the zero-sequence current transformer 7, and the zero-sequence current transformer 7 is configured to detect the leakage current in the circuit. When the zero-sequence current transformer 7 detects the leakage current, a signal is fed back to the control circuit board 6. After setting the signal, the control circuit board 6 sends out a command to make the electromagnetic release 5 act. The reset member 44 is disposed at a side of the electromagnetic release 5, and when an output rod of the electromagnetic release 5 extends, the reset member 44 can be pushed to rotate. Meanwhile, the reset member 44 is linked with the lock latch 43. After receiving the push of the output rod of the electromagnetic release 5, the reset member 44 can be pushed against and act on the lock latch 43, thereby toggling the lock latch 43 to rotate, and unlocking the locked portion and the locking portion. After the locked portion and the locking portion are unbuckled, the tripping mechanism 40 quickly trips and opens, and the tripping member 41 rotates and cooperates with the operating mechanism of the circuit breaker unit 10 to achieve tripping and opening of the leakage protection unit 20 and the circuit breaker unit 10.

The above structure of the tripping mechanism 40 can refer to inventors' patent application CN114883154A.

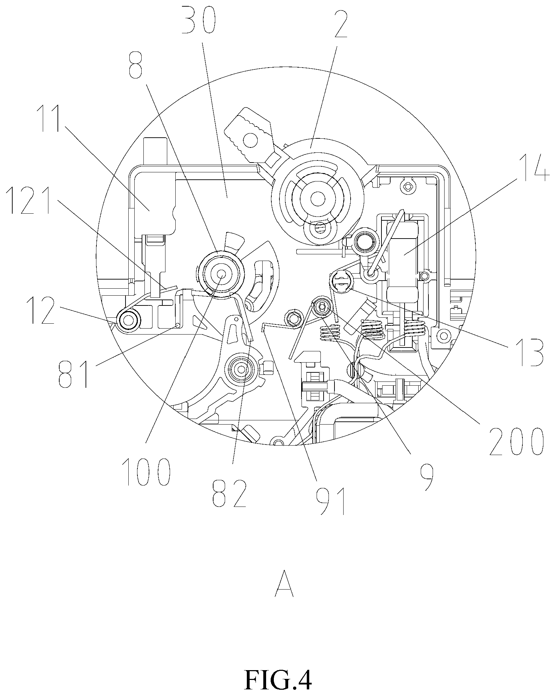

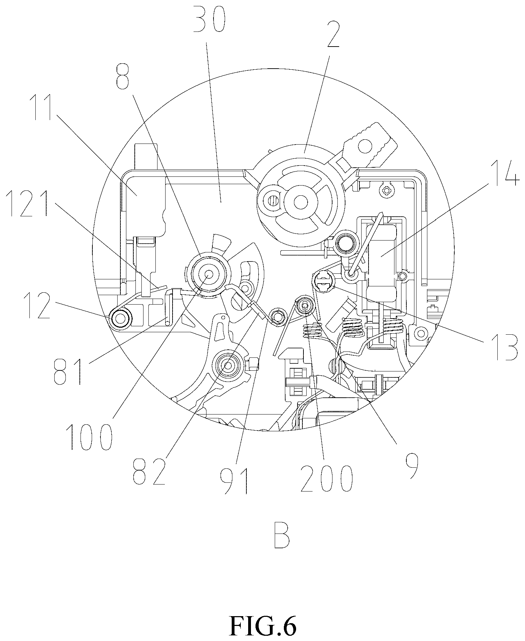

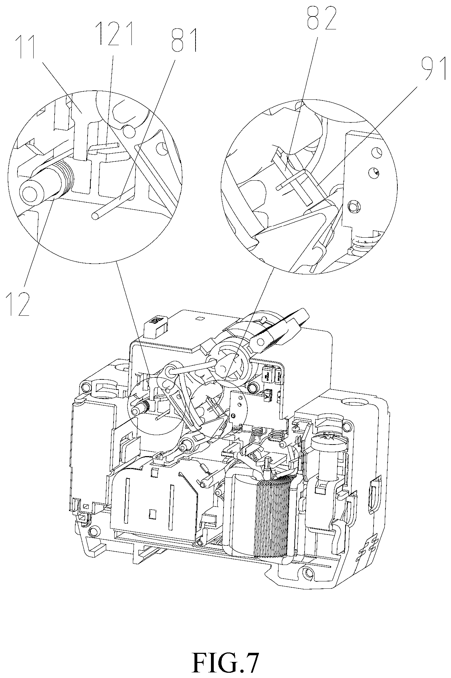

A first elastic member 8 and a second elastic member 9 are installed on the base 1 and configured to provide a first reset force and a second reset force for the tripping member 41 and the lock latch 43, respectively, thereby achieving rotational resetting of the tripping member 41 and the lock latch 43. The first elastic member 8 and the second elastic member 9 also serve as part of a double-breakpoint test mechanism of the circuit breaker, to achieve conduction of a test circuit. As shown in FIGS. 4, 6 and 7, the double-breakpoint test mechanism includes a test button 11, a test torsion spring 12, and a test resistor 14. The test button 11 is slidably installed on the base 1, and an outer end of the test button 11 is exposed out of the base 1. The base 1 is provided with a torsion spring shaft, and a helical portion of the test torsion spring 12 is socketed to the torsion spring shaft arranged on the base 1. The test torsion spring 12 also includes a first torsion arm and a second torsion arm 121. The first torsion arm of the test torsion spring 12 is connected to the test circuit, and the second torsion arm 121 is oppositely arranged at an inner end side of the button 11. The test resistor 14 and the test button 11 are spaced apart, and the first elastic member 8 and the second elastic member 9 are arranged between the test resistor 14 and the test button 11. In this embodiment, both the first elastic member 8 and the second elastic member 9 are torsion springs. The base 1 is provided with two torsion spring shafts as a first assembly site 100 and a second assembly site 200, and the first elastic member 8 and the second elastic member 9 are installed on the two torsion spring shafts of the first assembly site 100 and the second assembly site 200, respectively. The first elastic member 8 includes a third torsion arm 81 and a fourth torsion arm 82; the third torsion arm 81 is fixedly connected to the base 1; and the third torsion arm 81 is arranged close to the second torsion arm 121. When the test button 11 is pressed, the test button 11 can push the second torsion arm 121 of the test torsion spring 12 downwards, and hence the second torsion arm 121 has a first motion stroke. The third torsion arm 81 of the first elastic member 8 is arranged within a stroke range of the first motion stroke, so that the test button 11 can push the second torsion arm 121 of the test torsion spring 12 into lapping contact with the third torsion arm 81 of the first elastic member 8 to achieve conduction. When the test button 11 is not pressed, the third torsion arm 81 and the second torsion arm 121 are disconnected, thereby forming a first breakpoint of the test circuit. The fourth torsion arm 82 as a reset end of the first elastic member 8 acts on the tripping member 41 to provide the first reset force for the tripping member 41. Specifically, the fourth torsion arm 82 may be fixedly connected to the tripping member 41 or may abut against the tripping member 41. When the tripping member 41rotating, the tripping member 41 also pushes the fourth torsion arm 82 to swing, and hence the fourth torsion arm 82 has a second motion stroke. The second elastic member 9 includes a fifth torsion arm 91 arranged within a stroke range of the second motion stroke of the fourth torsion arm 82. The tripping member 41 is linked and connected with the operating mechanism of the circuit breaker unit 1. When the circuit breaker is closed, the tripping member 41 rotates and can bring the fourth torsion arm 82 into lapping contact with the fifth torsion arm 91 to achieve conduction. When the circuit breaker is opened, the fourth torsion arm 82 and the fifth torsion arm 91 are disconnected, thereby forming a second breakpoint of the test circuit.

A third elastic member 13 is also provided between the second elastic member 9 and the test resistor 14, and in this embodiment, the third elastic member 13 is also a torsion spring. One of torsion arms of the third elastic member 13 maintains electrical contact with the second elastic member 9 through elastic force, while the other torsion arm of the third elastic member 13 maintains electrical contact with one end of the test resistor 14 through elastic force; and another end of the test resistor 14 is connected to the test circuit. Specifically, in this embodiment, the first torsion arm of the test torsion spring 12 is electrically connected to an arc plate of an N pole of the circuit breaker unit 10; another end of the test resistor 14 is soldered to a signal wire, and in turn the signal wire is soldered to a wiring portion of a L pole of the circuit breaker unit 10. In such a way, the test circuit can connect the N pole and the L pole to detect the leakage current after the first breakpoint and the second breakpoint are connected. The third elastic member 13 is not necessary; in other embodiments, another torsion arm (not the fifth torsion arm 91) may extend from the second elastic member 9, and is fixedly connected to the base 1 while extending to the one end of the test resistor 14 to be electrically connected to the test resistor 14. However, in this way, the electrical connection between the second elastic member 9 and the test resistor 14 may not be reliable. In this embodiment, the third elastic member 13 is provided, which can reliably make electrical contact with the second elastic member 9 and the test resistor 14 by utilizing elastic compression force of two torsion arms of the third elastic member 13, to ensure reliable conduction of the test circuit.

The test circuit in this embodiment forms a double-breakpoint design, and the second breakpoint is only connected when the circuit breaker is closed, which improves safety performance. Most importantly, this embodiment forms the test circuit by utilizing the first elastic member 8 and the second elastic member 9 already relevant in the original tripping mechanism 40, so that the components are highly integrated without need for additional conductive components, the structure is simple, and the cost is low.

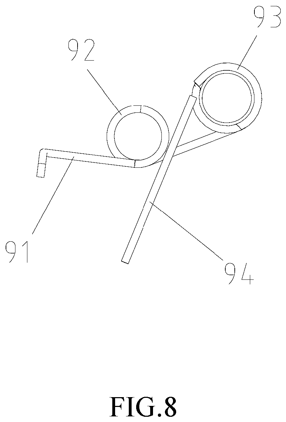

In this embodiment, the test button 11 is at a left side of the test resistor 14, and the test resistor 14 is at a right side of the test button 11; the test button 11 is close to a left end housing of the base 1, and the test resistor 14 is close to a right end housing of the base 1. As a result, a spacing width between the test resistor 14 and the test button 11 is maximized to provide sufficient space for arranging the first elastic member 8, the second elastic member 9, and a connection spring 13 (i.e. third elastic member 13). The first elastic member 8, the second elastic member 9, and the connection spring 13 are arranged in sequence from left to right. In this embodiment, the second elastic member 9 is a double-torsion spring (a twin-torsion spring), and such arrangement allows the second elastic member 9 to have a large span over a range of the spacing width between the test resistor 14 and the test button 11, which facilitates the connection of the second elastic member 9 with the first elastic member 8 and the third elastic member 13, and this structure also facilitates installation. As shown in FIGS. 4 and 8, the second elastic member 9 specifically includes a first helical portion 92, a second helical portion 93, a fifth torsion arm 91, and a sixth torsion arm 94. The first helical portion 92 is closer to the test button 11 than the second helical portion 93. The fifth torsion arm 91 extends from the first helical portion 92, and the sixth torsion arm 94 extends from the second helical portion 93. The sixth torsion arm 94 abuts against the lock latch 43 by its own elastic force, to reset the lock latch 43. One torsion arm of the third elastic member 13 abuts against the second helical portion 93 through elastic force.

In this embodiment, respective torsion spring shafts used for installing the test torsion spring 12, the first elastic member 8, and the second elastic member 9 are all protruding in a direction perpendicular to the partition plate 30. The second torsion arm 121 includes a first contact portion parallel to the partition plate 30, and the third torsion arm 81 includes a second contact portion perpendicular to the partition plate 30, so that the first contact portion of the second torsion arm 121 and the second contact portion of the third torsion arm 81 are perpendicularly opposed to each other, improving the contact reliability of lapping conduction between the second torsion arm 121 and the third torsion arm 81. Similarly, the fourth torsion arm 82 and the fifth torsion arm 91 are designed in the same way that their contact portions are perpendicularly opposed to each other. That is, the fourth torsion arm 82 may be provided with a third contact portion, and the fifth torsion arm 91 may be provided with a fourth contact portion corresponding to the third contact portion, in which the third contact portion and the fourth contact portion are perpendicularly opposed to each other. Any group of two opposing contact portions described above may also be staggered at an angle not equal to 90° in other embodiments.

In other embodiments, the first elastic member 8, the second elastic member 9, and the third elastic member 13 may also be implemented using other elastic member structures, such as a clockwork, an elastic piece, a cylindrical spring, or a combination structure of an elastic piece and a cylindrical spring. In order to achieve the same function as the first elastic member 8, the second elastic member 9, and the third elastic member 13 in this embodiment, it is obviously attainable for the person skilled in the art to make adaptive substitutions using similar elastic member structures. As commonly used rotating reset members, the first elastic member 8 and the second elastic member 9, which adopt torsion spring structures, can be quickly upgraded based on the original tripping mechanism 40 without complex structural modifications. Overall, only installation sites of the torsion springs and positions of the torsion arms need to be adjusted. Moreover, the first elastic member 8, the second elastic member 9, and the third elastic member 13 all adopt torsion spring structures, which can facilitate product assembly and save installation space.

## Claims

1. A double-breakpoint test mechanism applied to a circuit breaker, comprising a test button (11), a test torsion spring (12), and
a first elastic member (8), which is configured to provide a reset force and perform contact conduction,
**characterised in that** the double-breakpoint test mechanism futher comprises:
a second elastic member (9) configured to provide a reset force and perform contact conduction,
the first elastic member (8) and the second elastic member (9) are assembled in a first assembly site (100) and a second assembly site (200) respectively to provide a first reset force and a second reset force for a tripping mechanism (40) of the circuit breaker; and
when the first elastic member (8) and the second elastic member (9) are in the first assembly site (100) and the second assembly site (200) respectively, a first breakpoint is formed between the test torsion spring (12) and the first elastic member (8), and a second breakpoint is formed between the first elastic member (8) and the second elastic member (9);
the first elastic member (8) comprises a first end close to the test torsion spring (12) and a second end close to the second elastic member (9);
the test torsion spring (12) is pushed by the test button (11) to have a first motion stroke, and the first end of the first elastic member (8) is arranged within a stroke range of the first motion stroke, allowing the test button (11) to push the test torsion spring (12) into contact conduction with the first end of the first elastic member (8); and
when the circuit breaker is closed, the second end of the first elastic member (8) is pushed by the tripping mechanism (40) to have a second motion stroke, and the second elastic member (9) is arranged within a stroke range of the second motion stroke, allowing the tripping member to push the second end of the first elastic member (8) into contact conduction with the second elastic member (9) when the circuit breaker is closed.

2. The double-breakpoint test mechanism applied to a circuit breaker according to claim 1, **characterized in that** both the first elastic member (8) and the second elastic member (9) are torsion springs; two torsion arms of the first elastic member (8) serve as the first end and the second end; one torsion arm of the second elastic member (9) is arranged within the stroke range of the second motion stroke.

3. The double-breakpoint test mechanism applied to a circuit breaker according to claim 1 or 2, **characterized in that** the double-breakpoint test mechanism further comprises:
a test resistor (14); and
a third elastic member (13), one end of the third elastic member (13) keeps contact conduction with the second elastic member (9) through elastic force, and another end of the third elastic member (13) keeps contact conduction with the test resistor (14) through elastic force.

4. The double-breakpoint test mechanism applied to a circuit breaker according to claim 3, **characterized in that** the test button (11) and the test resistor (14) are spaced apart, and the first elastic member (8), the second elastic member (9) and the third elastic member (13) are sequentially arranged between the test button (11) and the test resistor (14).

5. The double-breakpoint test mechanism applied to a circuit breaker according to claim 3 or 4, **characterized in that** the second elastic member (9) is a double-torsion spring and comprises a first helical portion (92) and a second helical portion (93), the first helical portion (92) being closer to the test button (11) than the second helical portion (93).

6. The double-breakpoint test mechanism applied to a circuit breaker according to any one of the preceding claims, **characterized in that** the test torsion spring (12) comprises a first contact portion configured to contact the first elastic member (8), and the first elastic member (8) comprises a second contact portion corresponding to the first contact portion, the first contact portion and the second contact portion being staggered opposite to each other; and/or
the first elastic member (8) comprises a third contact portion configured to contact the second elastic member (9), and the second elastic member (9) comprises a fourth contact portion corresponding to the third contact portion, the third contact portion and the fourth contact portion being staggered opposite to each other.

7. A circuit breaker, comprising a circuit breaker unit (10) and a leakage protection unit (20), and the leakage protection unit (20) comprising a tripping mechanism (40) and a test mechanism,
**characterized in that** the test mechanism is the double-breakpoint test mechanism according to any one of the preceding claims; and
the circuit breaker further comprises a first assembly site (100) and a second assembly site (200), the first elastic member (8) and the second elastic member (9) being assembled in the first assembly site (100) and the second assembly site (200) respectively to provide a first reset force and a second reset force for the tripping mechanism (40).

8. The circuit breaker according to claim 7, **characterized in that** the circuit breaker further comprises a base (1), and the tripping mechanism (40) comprises a tripping member (41), a tripping latch (42), a lock latch (43), and a reset member (44); the tripping member (41), the lock latch (43), and the reset member (44) are pivotally connected to the base (1); the tripping latch (42) is pivotally connected to the tripping member (41); and the first elastic member (8) and the second elastic member (9) are rotating reset members (44) for the tripping member (41) and the lock latch (43) respectively.

9. The circuit breaker according to claim 7, **characterized in that** the circuit breaker further comprises a base (1),
the test mechanism further comprises a third elastic member (13) and a test resistor (14);
one end of the third elastic member (13) keeps contact conduction with the second elastic member (9) through elastic force, and another end of the third elastic member (13) keeps contact conduction with the test resistor (14) through elastic force;
the test button (11) and the test resistor (14) are spaced apart, the test button (11) being at a left side of the test resistor (14), the test resistor (14) being at a right side of the test button (11);
the test button (11) is close to a left end housing of the base (1), and the test resistor (14) is close to a right end housing of the base (1); and
the first elastic member (8) and the second elastic member (9) are arranged in sequence from left to right between the test button (11) and the test resistor (14).

## Patentansprüche

1. Doppel-Unterbrechungspunkt-Testmechanismus angewendet auf einen Schutzschalter, umfassend einen Testknopf (11), eine Test-Torsionsfeder (12), und
ein erstes elastisches Element (8), das konfiguriert ist, um eine Rückstellkraft bereitzustellen und die Kontaktleitung durchzuführen,
**dadurch gekennzeichnet, dass** der Testmechanismus mit doppeltem Bruchpunkt weiter umfasst:
ein zweites elastisches Element (9), das konfiguriert ist, um eine Rückstellkraft bereitzustellen und die Kontaktleitung durchzuführen,
das erste elastische Element (8) und das zweite elastische Element (9) in einer ersten Montagestelle (100) bzw. einer zweiten Montagestelle (200) montiert sind, um eine erste Rückstellkraft und eine zweite Rückstellkraft für einen Auslösemechanismus (40) des Schutzschalters bereitzustellen; und
wenn sich das erste elastische Element (8) und das zweite elastische Element (9) an der ersten Montagestelle (100) bzw. an der zweiten Montagestelle (200) befinden, eine erste Bruchstelle zwischen der Test-Torsionsfeder (12) und dem ersten elastischen Element (8) und eine zweite Bruchstelle zwischen dem ersten elastischen Element (8) und dem zweiten elastischen Element (9) gebildet wird;
das erste elastische Element (8) ein erstes Ende in der Nähe der Test-Torsionsfeder (12) und ein zweites Ende in der Nähe des zweiten elastischen Elements (9) umfasst;
die Test-Torsionsfeder (12) durch den Testknopf (11) gedrückt wird, um einen ersten Bewegungshub aufzuweisen, und das erste Ende des ersten elastischen Elements (8) innerhalb eines Hubbereichs des ersten Bewegungshubs angeordnet ist, was es dem Testknopf (11) ermöglicht, die Test-Torsionsfeder (12) in Kontaktleitung mit dem ersten Ende des ersten elastischen Elements (8) zu drücken; und
wenn der Schutzschalter geschlossen ist, das zweite Ende des ersten elastischen Elements (8) durch den Auslösemechanismus (40) gedrückt wird, um einen zweiten Bewegungshub aufzuweisen, und das zweite elastische Element (9) innerhalb eines Hubbereichs des zweiten Bewegungshubs angeordnet ist, was es dem Auslöseelement ermöglicht, das zweite Ende des ersten elastischen Elements (8) in Kontaktleitung mit dem zweiten elastischen Element (9) zu drücken, wenn der Schutzschalter geschlossen ist.

2. Testmechanismus mit doppeltem Bruchpunkt angewendet auf einen Schutzschalter nach Anspruch 1, **dadurch gekennzeichnet, dass** sowohl das erste elastische Element (8) als auch das zweite elastische Element (9) Torsionsfedern sind; zwei Torsionsarme des ersten elastischen Elements (8) als erstes und zweites Ende dienen; ein Torsionsarm des zweiten elastischen Elements (9) innerhalb des Hubbereiches des zweiten Bewegungshubes angeordnet ist.

3. Testmechanismus mit doppeltem Bruchpunkt angewendet auf einen Schutzschalter nach Anspruch 1 oder 2, **dadurch gekennzeichnet, dass** der Testmechanismus mit doppeltem Bruchpunkt weiter umfasst:
einen Testwiderstand (14); und
ein drittes elastisches Element (13), wobei ein Ende des dritten elastischen Elements(13) durch elastische Kraft eine Kontaktleitung mit dem zweiten elastischen Element (9) aufrechterhält und ein anderes Ende des dritten elastischen Elements (13) durch elastische Kraft eine Kontaktleitung mit dem Testwiderstand (14) aufrechterhält.

4. Testmechanismus mit doppeltem Bruchpunkt angewendet auf einen Schutzschalter nach Anspruch 3, **dadurch gekennzeichnet, dass** der Testknopf (11) und der Testwiderstand (14) voneinander beabstandet sind, und das erste elastische Element (8), das zweite elastische Element (9) und das dritte elastische Element (13) nacheinander zwischen dem Testknopf (11) und dem Testwiderstand (14) angeordnet sind.

5. Testmechanismus mit doppeltem Bruchpunkt angewendet auf einen Schutzschalter nach Anspruch 3 oder 4, **dadurch gekennzeichnet, dass** das zweite elastische Element (9) eine Doppeltorsionsfeder ist und einen ersten schraubenförmigen Abschnitt (92) und einen zweiten schraubenförmigen Abschnitt (93) umfasst, wobei der erste schraubenförmige Abschnitt (92) näher an dem Testknopf (11) liegt als der zweite schraubenförmige Abschnitt (93).

6. Testmechanismus mit doppeltem Bruchpunkt angewendet auf einen Schutzschalter nach einem der vorstehenden Ansprüche, **dadurch gekennzeichnet, dass** die Test-Torsionsfeder (12) einen ersten Kontaktabschnitt umfasst, der konfiguriert ist, um das erste elastische Element (8) zu berühren, und das erste elastische Element (8) einen zweiten Kontaktabschnitt umfasst, der dem ersten Kontaktabschnitt entspricht, wobei der erste Kontaktabschnitt und der zweite Kontaktabschnitt einander gegenüberliegend versetzt sind; und/oder
das erste elastische Element (8) einen dritten Kontaktabschnitt umfasst, der konfiguriert ist, um das zweite elastische Element (9) zu berühren, und das zweite elastische Element (9) einen vierten Kontaktabschnitt umfasst, der dem dritten Kontaktabschnitt entspricht, wobei der dritte Kontaktabschnitt und der vierte Kontaktabschnitt einander gegenüberliegend versetzt sind.

7. Schutzschalter, der eine Schutzschaltereinheit (10) und eine Leckschutzeinheit (20) umfasst, wobei die Leckschutzeinheit (20) einen Auslösemechanismus (40) und einen Testmechanismus umfasst,
**dadurch gekennzeichnet, dass** der Testmechanismus ein Testmechanismus mit doppeltem Bruchpunkt nach einem der vorstehenden Ansprüche ist; und
der Schutzschalter weiterhin eine erste Montagestelle (100) und eine zweite Montagestelle (200) umfasst, wobei das erste elastische Element (8) und das zweite elastische Element (9) in der ersten Montagestelle (100) bzw. der zweiten Montagestelle (200) montiert sind, um eine erste Rückstellkraft und eine zweite Rückstellkraft für den Auslösemechanismus (40) bereitzustellen.

8. Schutzschalter nach Anspruch 7, **dadurch gekennzeichnet, dass** der Schutzschalter weiter eine Basis (1) umfasst und der Auslösemechanismus (40) ein Auslöseelement (41), eine Auslöseklinke (42), eine Sperrklinke (43), und ein Rückstellelement (44) umfasst; das Auslöseelement (41), die Sperrklinke (43) und das Rückstellelement (44) schwenkbar mit der Basis (1) verbunden sind; die Auslöseklinke (42) schwenkbar mit dem Auslöseelement (41) verbunden ist; und das erste elastische Element (8) und das zweite elastische Element (9) drehbare Rückstellelemente (44) für das Auslöseelement (41) bzw. die Sperrklinke (43) sind.

9. Schutzschalter nach Anspruch 7, **dadurch gekennzeichnet, dass** der Schutzschalter weiterhin eine Basis (1) umfasst,
der Testmechanismus weiter ein drittes elastisches Element (13) und einen Testwiderstand (14) umfasst;
ein Ende des dritten elastischen Elements (13) durch elastische Kraft in Kontakt mit dem zweiten elastischen Element (9) bleibt, und ein anderes Ende des dritten elastischen Elements (13) durch elastische Kraft in Kontakt mit dem Testwiderstand (14) bleibt;
der Testknopf (11) und der Testwiderstand (14) voneinander beabstandet sind, wobei sich die Testknopf (11) an einer linken Seite des Testwiderstands (14) befindet und der Testwiderstand (14) sich an einer rechten Seite der Testknopf (11) befindet;
der Testknopf (11) sich in der Nähe eines linken Endgehäuses der Basis (1) befindet und der Testwiderstand (14) sich in der Nähe eines rechten Endgehäuses der Basis (1) befindet; und
das erste elastische Element (8) und das zweite elastische Element (9) in der Reihenfolge von links nach rechts zwischen dem Testknopf (11) und dem Testwiderstand (14) angeordnet sind.

## Revendications

1. Mécanisme de test à double point de rupture appliqué à un disjoncteur, comprenant un bouton de test (11), un ressort de torsion de test (12), et
un premier élément élastique (8), qui est configuré pour fournir une force de rappel et réaliser une conduction de contact,
**caractérisé en ce que** le mécanisme de test à double point de rupture comprend en outre : un deuxième élément élastique (9) configuré pour fournir une force de rappel et réaliser une conduction de contact,
le premier élément élastique (8) et le deuxième élément élastique (9) sont assemblés dans un premier emplacement d'assemblage (100) et un second emplacement d'assemblage (200) respectivement pour fournir une première force de rappel et une seconde force de rappel pour un mécanisme de déclenchement (40) du disjoncteur ; et
lorsque le premier élément élastique (8) et le deuxième élément élastique (9) sont dans le premier emplacement d'assemblage (100) et le second emplacement d'assemblage (200) respectivement, un premier point de rupture est formé entre le ressort de torsion de test (12) et le premier élément élastique (8), et un second point de rupture est formé entre le premier élément élastique (8) et le deuxième élément élastique (9) ;
le premier élément élastique (8) comprend une première extrémité proche du ressort de torsion de test (12) et une seconde extrémité proche du deuxième élément élastique (9) ;
le ressort de torsion de test (12) est poussé par le bouton de test (11) pour présenter une première course de mouvement, et la première extrémité du premier élément élastique (8) est agencée dans une plage de course de la première course de mouvement, permettant au bouton de test (11) de pousser le ressort de torsion de test (12) en conduction de contact avec la première extrémité du premier élément élastique (8) ; et
lorsque le disjoncteur est fermé, la seconde extrémité du premier élément élastique (8) est poussée par le mécanisme de déclenchement (40) pour présenter une seconde course de mouvement, et le deuxième élément élastique (9) est agencé dans une plage de course de la seconde course de mouvement, permettant à l'élément de déclenchement de pousser la seconde extrémité du premier élément élastique (8) en conduction de contact avec le deuxième élément élastique (9) lorsque le disjoncteur est fermé.

2. Mécanisme de test à double point de rupture appliqué à un disjoncteur selon la revendication 1, **caractérisé en ce que** le premier élément élastique (8) et le deuxième élément élastique (9) sont tous deux des ressorts de torsion ; deux bras de torsion du premier élément élastique (8) servent de première extrémité et de seconde extrémité ; un bras de torsion du deuxième élément élastique (9) est agencé dans la plage de course de la seconde course de mouvement.

3. Mécanisme de test à double point de rupture appliqué à un disjoncteur selon la revendication 1 ou la revendication 2, **caractérisé en ce que** le mécanisme de test à double point de rupture comprend en outre :
une résistance de test (14) ; et
un troisième élément élastique (13), une extrémité du troisième élément élastique (13) maintient la conduction de contact avec le deuxième élément élastique (9) par une force élastique, et une autre extrémité du troisième élément élastique (13) maintient la conduction de contact avec la résistance de test (14) par une force élastique.

4. Mécanisme de test à double point de rupture appliqué à un disjoncteur selon la revendication 3, **caractérisé en ce que** le bouton de test (11) et la résistance de test (14) sont espacés l'un de l'autre, et le premier élément élastique (8), le deuxième élément élastique (9) et le troisième élément élastique (13) sont agencés séquentiellement entre le bouton de test (11) et la résistance de test (14).

5. Mécanisme de test à double point de rupture appliqué à un disjoncteur selon la revendication 3 ou la revendication 4, **caractérisé en ce que** le deuxième élément élastique (9) est un ressort à double torsion et comprend une première partie hélicoïdale (92) et une seconde partie hélicoïdale (93), la première partie hélicoïdale (92) étant plus proche du bouton de test (11) que la seconde partie hélicoïdale (93).

6. Mécanisme de test à double point de rupture appliqué à un disjoncteur selon l'une quelconque des revendications précédentes, **caractérisé en ce que** le ressort de torsion de test (12) comprend une première partie de contact configurée pour entrer en contact avec le premier élément élastique (8), et le premier élément élastique (8) comprend une deuxième partie de contact correspondant à la première partie de contact, la première partie de contact et la deuxième partie de contact étant décalées l'une par rapport à l'autre ; et/ou
le premier élément élastique (8) comprend une troisième partie de contact configurée pour entrer en contact avec le deuxième élément élastique (9), et le deuxième élément élastique (9) comprend une quatrième partie de contact correspondant à la troisième partie de contact, la troisième partie de contact et la quatrième partie de contact étant décalées l'une par rapport à l'autre.

7. Disjoncteur, comprenant une unité de disjoncteur (10) et une unité de protection contre les fuites (20), et l'unité de protection contre les fuites (20) comprenant un mécanisme de déclenchement (40) et un mécanisme de test,
**caractérisé en ce que** le mécanisme de test est le mécanisme de test à double point de rupture selon l'une quelconque des revendications précédentes ; et
le disjoncteur comprend en outre un premier emplacement d'assemblage (100) et un second emplacement d'assemblage (200), le premier élément élastique (8) et le deuxième élément élastique (9) étant assemblés dans le premier emplacement d'assemblage (100) et le second emplacement d'assemblage (200) respectivement pour fournir une première force de rappel et une seconde force de rappel pour le mécanisme de déclenchement (40).

8. Disjoncteur selon la revendication 7, **caractérisé en ce que** le disjoncteur comprend en outre une base (1), et le mécanisme de déclenchement (40) comprend un élément de déclenchement (41), un loquet de déclenchement (42), un loquet de verrouillage (43), et un élément de rappel (44) ; l'élément de déclenchement (41), le loquet de verrouillage (43) et l'élément de rappel (44) sont reliés de manière pivotante à la base (1) ; le loquet de déclenchement (42) est relié de manière pivotante à l'élément de déclenchement (41) ; et le premier élément élastique (8) et le deuxième élément élastique (9) sont des éléments de rappel (44) rotatifs pour l'élément de déclenchement (41) et le loquet de verrouillage (43), respectivement.

9. Disjoncteur selon la revendication 7, **caractérisé en ce que** le disjoncteur comprend en outre une base (1),
le mécanisme de test comprend en outre un troisième élément élastique (13) et une résistance de test (14) ;
une extrémité du troisième élément élastique (13) maintient la conduction de contact avec le deuxième élément élastique (9) par une force élastique, et une autre extrémité du troisième élément élastique (13) maintient la conduction de contact avec la résistance de test (14) par une force élastique ;
le bouton de test (11) et la résistance de test (14) sont espacés, le bouton de test (11) étant sur un côté gauche de la résistance de test (14), la résistance de test (14) étant sur un côté droit du bouton de test (11) ;
le bouton de test (11) est proche d'un boîtier d'extrémité gauche de la base (1), et la résistance de test (14) est proche d'un boîtier d'extrémité droite de la base (1) ; et
le premier élément élastique (8) et le deuxième élément élastique (9) sont agencés en séquence de gauche à droite entre le bouton de test (11) et la résistance de test (14).
